# EUROPEAN PATENT SPECIFICATION

(11) **EP 4 220 195 B1**
(45) Date of publication and mention of the grant of the patent: **30.10.2024**
(21) Application number: 22730043.1
(22) Date of filing: 25.02.2022
(51) Int. Cl.: G01R 11/24

(54) **SINGLE-PHASE ELECTRIC ENERGY METERING CHIP CAPABLE OF ANTI-TAMPERING WITH NEUTRAL MISSING**
EINPHASIGER ELEKTRISCHER ENERGIEMESSUNGSCHIP MIT SCHUTZ GEGEN VERFÄLSCHUNG DURCH MANGELNDEN NEUTRALLEITER
PUCE DE MESURE D'ÉNERGIE ÉLECTRIQUE MONOPHASÉE POUR UNE APPLICATION DE PRÉVENTION DE VOL D'ÉLECTRICITÉ PAR DÉRIVATION DE FIL NEUTRE

(30) Priority: 15.12.2021 CN 202111535659
(43) Date of publication of application: 02.08.2023
(73) Proprietor: Hangzhou Vango Technologies, Inc., Hangzhou, Zhejiang 310053 (CN)
(72) Inventor: CHEN, Bo, Hangzhou, Zhejiang 310053 (CN); MEN, Changyou, Hangzhou, Zhejiang 310053 (CN); CUI, Guoyu, Hangzhou, Zhejiang 310053 (CN)
(74) Representative: HGF
(86) International application number: PCT/CN2022/077868
(87) International publication number: WO 2023/108896

(56) References cited:
- CN-A- 107 607 760
- CN-A- 108 155 897
- CN-A- 110 794 188
- CN-A- 111 308 192
- CN-A- 112 098 712
- CN-A- 112 098 712
- CN-U- 210 294 369
- ANALOG DEVICES: "Energy Metering IC with On-Chip Fault and Missing Neutral Detection ADE7761A", 1 January 2006 (2006-01-01), XP093064718, Retrieved from the Internet <URL:https://www.analog.com/media/en/technical-documentation/data-sheets/ADE7761A.pdf>
- TEXAS INSTRUMENTS: "One-Phase Shunt Electricity Meter Reference Design Using Standalone ADCs Description", 1 February 2021 (2021-02-01), XP093064722, Retrieved from the Internet <URL:https://www.ti.com/lit/ug/tiduem7a/tiduem7a.pdf?ts=1689752988955> [retrieved on 20230718]

## Description

### TECHNICAL FIELD

The present invention belongs to the field of electric power, and more particularly, to a single-phase electric energy metering chip capable of realizing anti-tampering with neutral missing.

### BACKGROUND

Anti-tampering with neutral missing is a common way to steal electricity, in which a user usually removes a neutral wire (N) connected to an electric energy meter. In this case, the electric energy meter cannot work because there is no power supply, and there is no a voltage signal but only a current signal, so the electric energy meter cannot measure the electric energy normally. Metering of anti-tampering with neutral missing is a way of preventing electricity stealing which uses a battery or a PT (Potential Transformer) as a standby power supply and uses a current effective value for measurement when the user steals electricity by dropping the neutral wire. When the PT is used as the standby power supply, the PT is used to obtain a power supply from a current sampling loop.

There are many ways to realize metering of anti-tampering with neutral missing. In the field of metering of anti-tampering with neutral missing, due to the consideration of cost and power consumption, an electric energy metering SOC (System On Chip) is usually used to realize the metering of anti-tampering with neutral missing. The electric energy metering SOC is a chip that integrates a power metering module and a MCU (Microcontroller Unit). With the development of technology, the limitation of using the SOC to realize the metering of anti-tampering with neutral missing is becoming more and more obvious. The main reasons are as follows.

The metering of anti-tampering with neutral missing is mainly realized by a metering module in the SOC, while functions of the electric energy meter are completed by the MCU. With the development of electric energy meter technologies, users have more and more function demands on the electric energy meters, and meanwhile, the demands are more and more diversified. Therefore, the demands on the MCU are becoming diversified and high-end. However, there is no obvious change in preventing electricity stealing. Because the SOC integrates the metering module and the MCU on one chip, independent combination of metering electricity stealing prevention and multiple MCUs cannot be realized. Secondly, a more advanced manufacturing process may be adopted for a digital part of the MCU to reduce a wafer area, thus reducing the cost, while the metering part is mainly an analog circuit. Considering the reliability and metering accuracy, it is impossible to adopt a more advanced manufacturing process. Due to this limitation, the manufacturing cost of the electric energy metering SOC cannot be reduced.

Considering the market demands and design cost, it is a trend to adopt a MCU plus a single-phase metering chip to realize metering of anti-tampering with neutral missing, but there is still no single-phase metering chip on the market to better meet the above market demands at present.

Examples of the state of the art include the following:
- Analog Devices, "Energy Metering IC with On-Chip Fault and Missing Neutral Detection ADE7761A", (20060101), URL: https://www.analog.com/media/en/technical-documentation/data-sheets/ADE7761A pdf; and
   Texas Instruments, "One-Phase Shunt Electricity Meter Reference Design Using Standalone ADCs Description", (20210201), URL: https://www.ti.com/lit/ug/tiduem7a/tiduem7a.pdf?ts=1689752988955, (2023071 8).

### SUMMARY

Object of the present invention: the technical problem to be solved by the present invention is to provide a single-phase electric energy metering chip capable of realizing anti-tampering with neutral missing aiming at the deficiencies of the prior art.

In order to solve the foregoing technical problem, the present invention discloses a single-phase electric energy metering chip capable of realizing anti-tampering with neutral missing, comprising a working mode control circuit, an ADC sampling circuit, a current effective value measuring circuit, a judgment circuit for anti-tampering with neutral missing, an electric energy metering circuit and a clock circuit, wherein:
the working mode control circuit is configured for being connected to a main control chip, receiving a control signal which is configured for judging whether a main power supply is powered on and sent by the main control chip, and selecting a working mode of the single-phase electric energy metering chip according to the result whether the main power supply is powered on;
the ADC sampling circuit is configured for sampling a current signal to obtain a digital signal;
the current effective value measuring circuit is configured for measuring a current effective value;
the judgment circuit for anti-tampering with neutral missing is configured for prejudging the digital signal to judge whether a current loop has a current, and if the current loop has a current, accurately judging the current effective value; and if the current effective value exceeds a threshold of anti-tampering with neutral missing, judging that it is necessary to perform metering of anti-tampering with neutral missing;
the electric energy metering circuit is configured for performing energy calculation on the current effective value to obtain an energy pulse; and
the clock circuit is configured for providing a clock source for the working mode control circuit, the ADC sampling circuit, the current effective value measurement circuit, the judgment circuit for anti-tampering with neutral missing and the electric energy metering circuit.

Further, the working mode comprises a normal metering mode, a low power consumption standby mode, a timed wake-up working mode and a metering mode of anti-tampering with neutral missing; when the main power supply is powered on, the single-phase electric energy metering chip enters the normal metering mode; and when the main power supply is not powered on, the single-phase electric energy metering chip enters the low power consumption standby mode, and under the low power consumption standby mode, the ADC sampling circuit, the current effective value measuring circuit and the judgment circuit for anti-tampering with neutral missing are in standby state, and the electric energy metering circuit is in a standby state or working state.

Further, the working mode control circuit comprises a working mode control pin, a control pin monitoring circuit, a low power consumption timer and a working mode switching circuit,
the working mode control pin is configured for being connected to the main control chip and receiving the control signal sent by the main control chip;
the control pin monitoring circuit is configured for monitoring the control signal, wherein when the main power supply is powered on, the single-phase electric energy metering chip enters the normal metering mode, and when the main power supply is not powered on, the single-phase electric energy metering chip enters the low power consumption standby mode;
the low power consumption timer is configured for monitoring whether a timed wake-up period T is reached in the low power consumption standby mode, and waking up the single-phase electric energy metering chip to enter the timed wake-up working mode when the timed wake-up period T is reached; and the clock circuit provides a low frequency clock source for the low power consumption timer; and
the working mode switching circuit is configured for switching among the low power consumption standby mode, the timed wake-up working mode and the metering mode of anti-tampering with neutral missing.

When metering anti-tampering with neutral missing, running power consumption of the metering chip mainly comes from standby power consumption, instantaneous average power consumption during timed wake-up working, and power consumption of metering of anti-tampering with neutral missing. The single-phase electric energy metering chip is in the low power consumption standby mode most of the time, so the power consumption of the standby circuit in the working mode switching circuit needs to be as small as possible (recommended maximum power consumption is < 2 uA), and the design should be as simple as possible.

Further, the switching among the low power consumption standby mode, the timed wake-up working mode and the metering mode of anti-tampering with neutral missing comprises:
step 1: configuring, by the main control chip, preset parameters, wherein the preset parameters comprise:
   the timed wake-up period T for switching from the low power consumption standby mode to the timed wake-up working mode; and
   a working clock frequency of the ADC sampling circuit, a working clock frequency of the judgment circuit for anti-tampering with neutral missing, a working clock frequency of the current effective value measuring circuit and a working clock frequency of the electric energy metering circuit after entering the timed wake-up working mode;
step 2: entering, by the single-phase electric energy metering chip, the timed wake-up working mode to wake up the ADC sampling circuit and the judgment circuit for anti-tampering with neutral missing under the low power consumption standby mode when the timed wake-up period T is reached;
step 3: sampling, by the ADC sampling circuit, the current signal to obtain the digital signal; and pre-judging, by the judgment circuit for anti-tampering with neutral missing, the digital signal to judge whether the current loop has a current;
step 4: if the current loop does not have a current, quitting the timed wake-up working mode and re-entering the low power consumption standby mode; and if the current loop has a current, waking up the current effective value measuring circuit to measure the current effective value;
step 5: accurately judging, by the judgment circuit for anti-tampering with neutral missing, the current effective value, if the current effective value is below the threshold of anti-tampering with neutral missing, and the single-phase electric energy metering chip is also in the metering mode of anti-tampering with neutral missing at the moment, entering, by the electric energy metering circuit, the standby state, quitting the metering mode of anti-tampering with neutral missing and the timed wake-up working mode, and entering the low power consumption standby mode; if the single-phase electric energy metering chip is not in the metering mode of anti-tampering with neutral missing at the moment, quitting the timed wake-up working mode and entering the low power consumption standby mode; and after entering the low power consumption standby mode, repeating step 2; and
   if the current effective value exceeds the threshold of anti-tampering with neutral missing, and the single-phase electric energy metering chip is in the metering mode of anti-tampering with neutral missing, performing step 6; otherwise, waking up the electric energy metering circuit to enter the metering mode of anti-tampering with neutral missing to perform 6; and
step 6: performing, by the electric energy metering circuit, energy accumulation calculation on the current effective value to obtain the energy pulse; and keeping, by the single-phase electric energy metering chip, the metering mode of anti-tampering with neutral missing, which means that the electric energy metering circuit being in the working mode and the single-phase electric energy metering chip entering the low power consumption standby mode at the same time, and repeating step 2.

Further, the pre-judging, by the judgment circuit for anti-tampering with neutral missing, the digital signal to judge whether the current loop has a current in step 3 comprises:
if sampling values of more than n continuous sampling points of the digital signal exceed a first threshold V within half cycle time, determining that a current passes through the current loop; otherwise, determining that no current passes through the current loop, wherein a value of n is set according to a number N of sampling points of the digital signal within one cycle time and the first threshold value V, and usually in a value range of N/4 to N/8; and
adopting, by the judgment circuit for anti-tampering with neutral missing, a high frequency clock as the clock source.

Further, the performing, by the electric energy metering circuit, energy accumulation calculation on the current effective value to obtain the energy pulse in step 6 comprises:
step 6.1: performing energy accumulation calculation on the current effective value to obtain energy data; and
step 6.2: judging whether the energy data reach a pulse threshold TH_{CF}, and if the energy data do not reach the pulse threshold TH_{CF}, continuing step 6.1; and
if the energy data reach the pulse threshold TH_{CF}, adding 1 to an energy pulse counter; if a CF output function is in an enabled state, outputting, by an output port, the energy pulse to the main control chip, and subtracting the pulse threshold Th_{CF} from the energy data at the same time, and then continuing step 6.1.

Further, in the metering mode of anti-tampering with neutral missing in step 6, the electric energy metering circuit adopts a low frequency clock as the clock source.

Further, the clock circuit comprises a low frequency clock signal input pin, a PLL (Phase Locked Loop) circuit, a clock selection circuit, a first frequency dividing circuit, a second frequency dividing circuit, a third frequency dividing circuit and a fourth frequency dividing circuit.

An input end of the low frequency clock signal input pin inputs a low frequency clock, a first output end of the low frequency clock signal input pin is connected with a low power consumption standby circuit, a second output end of the low frequency clock signal input pin is connected with a first input end of the clock selection circuit, and a third output end of the low frequency clock signal input pin is connected with an input end of the PLL circuit.
a first output end of the PLL circuit is connected with an input end of the first frequency dividing circuit, a second output end of the PLL circuit is connected with an input end of the second frequency dividing circuit, a third output end of the PLL circuit is connected with an input end of the third frequency dividing circuit, and a fourth output end of the PLL circuit is connected with an input end of the fourth frequency dividing circuit; the PLL circuit multiplies the low frequency clock to the high frequency clock, and clock output frequencies of each output end of the PLL circuit may be designed by each chip design company according to high frequency clock input of an original metering chip thereof.

An output end of the first frequency dividing circuit is connected with the ADC sampling circuit, an output end of the second frequency dividing circuit is connected with the judgment circuit for anti-tampering with neutral missing, an output end of the third frequency dividing circuit is connected with the current effective value measuring circuit, and an output end of the fourth frequency dividing circuit is connected with a second input end of the clock selection circuit; and
an output end of the clock selection circuit is connected with the electric energy metering circuit, when the working mode of the single-phase electric energy metering chip is the normal metering mode, the clock selection circuit outputs the high frequency clock, and when the working mode of the single-phase electric energy metering chip is the metering mode of anti-tampering with neutral missing, the clock selection circuit outputs the low frequency clock.

Further, the clock circuit comprises a communication port, a clock correction circuit, a low frequency oscillating circuit, a high frequency oscillating circuit, a clock selection circuit, a first frequency dividing circuit, a second frequency dividing circuit, a third frequency dividing circuit and a fourth frequency dividing circuit,
an input end of the communication port inputs training bytes sent by the main control chip, an output end of the communication port is connected with an input end of the clock correction circuit, a first output end of the clock correction circuit is connected with an input end of the low frequency oscillating circuit, and a second output end of the clock correction circuit is connected with an input end of the high frequency oscillating circuit;
a first output end of the low frequency oscillating circuit is connected with the low power consumption standby circuit, and an second output end of the low frequency oscillating circuit is connected with the first input end of the clock selection circuit;
a first output end of the high frequency oscillating circuit is connected with an input end of the first frequency dividing circuit, a second output end of the high frequency oscillating circuit is connected with an input end of the second frequency dividing circuit, a third output end of the high frequency oscillating circuit is connected with an input end of the third frequency dividing circuit, and a fourth output end of the high frequency oscillating circuit is connected with an input end of the fourth frequency dividing circuit;

An output end of the first frequency dividing circuit is connected with the ADC sampling circuit, an output end of the second frequency dividing circuit is connected with the judgment circuit for anti-tampering with neutral missing, an output end of the third frequency dividing circuit is connected with the current effective value measuring circuit, and an output end of the fourth frequency dividing circuit is connected with a second input end of the clock selection circuit; and
an output end of the clock selection circuit is connected with the electric energy metering circuit, when the working mode of the single-phase electric energy metering chip is the normal metering mode, the clock selection circuit outputs the high frequency clock, and when the working mode of the single-phase electric energy metering chip is the metering mode of anti-tampering with neutral missing, the clock selection circuit outputs the low frequency clock.

The clock selection circuit is added to the above two clock circuits, and the clock selection circuit comprises a low frequency clock option. In this way, when performing metering of anti-tampering with neutral missing, the clock of the energy metering circuit only needs to be switched to a low frequency clock, and it is not necessary to design an energy metering circuit for anti-tampering with neutral missing specially.

Further, the preset parameters in step 1 further comprise a measuring object of the current effective value measuring circuit, and the measuring object comprises simultaneous measurement of two current effective values of a live wire and a neutral wire, or measurement of either the current effective value of the live wire or the current effective value of the neutral wire; when the simultaneous measurement of the two current effective values of the live wire and the neutral wire is selected as the measuring object, after the waking up the current effective value measuring circuit to measure the current effective value in step 4, a large current effective value is selected to perform step 5 and step 6; and
if the current loop has a current in step 4, the current effective value measuring circuit is waken up to measure the current effective value after waiting for a time T1; and after the current effective value is measured, an ADC module and the current effective value measuring circuit enter the standby state.

### Beneficial effects:

The present application provides the novel single-phase electric energy metering chip with the metering function of anti-tampering with neutral missing, which integrates the metering function of anti-tampering with neutral missing into the metering chip. A MCU does not need to participate in the metering of electricity stealing prevention in the whole process of anti-tampering with neutral missing, but only needs to obtain the electric energy data through an external wake-up interrupt interface, thus greatly simplifying the design of neutral-wire electricity stealing prevention in the MCU and reducing the power consumption of anti-tampering with neutral missing, and allowing an electric energy meter designer to design a more competitive electric energy meter for anti-tampering with neutral missing based on the single-phase electric energy metering chip.

### BRIEF DESCRIPTION OF THE DRAWINGS

The advantages of the above and/or other aspects of the present invention will become more apparent by further explaining the present invention with reference to the following drawings and detailed description.
FIG. 1 is a schematic structural diagram of a MCU plus a single-phase metering chip to realize metering of anti-tampering with neutral missing in the related art.
FIG. 2 is a schematic structural diagram of a single-phase electric energy metering chip capable of realizing anti-tampering with neutral missing according to the embodiments of the present invention.
FIG. 3 is a flowchart of the single-phase electric energy metering chip capable of realizing anti-tampering with neutral missing for judging anti-tampering with neutral missing and measuring a current effective value according to the embodiments of the present invention.
FIG. 4 is a flowchart of the single-phase electric energy metering chip capable of realizing anti-tampering with neutral missing for metering an electric energy according to the embodiments of the present invention.
FIG. 5 is a flowchart of the single-phase electric energy metering chip capable of realizing anti-tampering with neutral missing for switching among four working nodes according to the embodiments of the present invention.
FIG. 6 is a first structural drawing of a clock circuit of the single-phase electric energy metering chip capable of realizing anti-tampering with neutral missing according to the embodiments of the present invention.
FIG. 7 is a second structural drawing of the clock circuit of the single-phase electric energy metering chip capable of realizing anti-tampering with neutral missing according to the embodiments of the present invention.
FIG. 8 is an original waveform data plot of current loop sampling of the single-phase electric energy metering chip capable of realizing anti-tampering with neutral missing according to the embodiments of the present invention.

### DETAILED DESCRIPTION

The embodiments of the present invention will be described hereinafter with reference to the drawings.

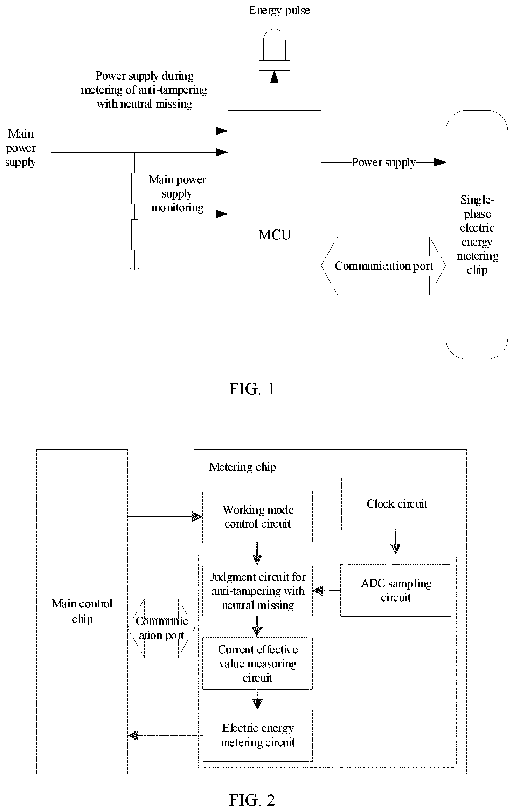

A design block diagram of a MCU plus a single-phase metering chip to realize metering of anti-tampering with neutral missing at present is as shown in FIG. 1. A main power supply is a power supply when an electric energy meter works normally, and when a neutral wire is connected to the electric energy meter normally, a MCU is powered by the main power supply. When the neutral wire is dropped, the MCU is powered by another power supply (from a battery or a dedicated power supply PT). A power supply of a metering chip is controlled by the MCU. When a main power supply monitoring circuit monitors that the electric energy meter is in a state of anti-tampering with neutral missing, the MCU turns off the power supply of the metering chip, and enters a low power consumption working state at the same time. In the low power consumption state, the MCU will wake up regularly and turn on the power supply of the metering chip, then initialize the metering chip through a communication interface, enable effective value measurement, read a current effective value after a period of time, and turn off the power supply of the metering chip. The MCU calculates an electric energy according to the current effective value, and generates an energy pulse (CF, Calibration Frequency). The above operation will be repeated periodically until the main power supply is powered on.

As described above, the existing MCU plus the metering chip for anti-tampering with neutral missing needs the MCU to wake up and control the metering chip constantly, and also needs the MCU to realize energy accumulation and output of energy pulse at the same time, which is not only complicated, but also difficult to achieve low power consumption. If low power consumption cannot be achieved, the cost of the overall solution will be uncompetitive. According to the present application, the metering function of anti-tampering with neutral missing above is integrated into the metering chip, and the MCU does not need to participate in metering of electricity stealing prevention in the whole process of anti-tampering with neutral missing, but only needs to obtain the electric energy data through an external wake-up interrupt interface, thus greatly simplifying the design of anti-tampering with neutral missing and reducing the power consumption of anti-tampering with neutral missing.

This embodiment discloses a single-phase electric energy metering chip capable of realizing anti-tampering with neutral missing, as shown in FIG. 2, comprising a working mode control circuit, an ADC sampling circuit, a current effective value measuring circuit, a judgment circuit for anti-tampering with neutral missing, an electric energy metering circuit and a clock circuit. There are also other circuits in the single-phase electric energy metering chip, which belong to the prior art, and are not limited in the embodiment of the present invention here.

The working mode control circuit is configured for being connected to a main control chip, receiving a control signal which is configured for judging whether a main power supply is powered on and sent by the main control chip, and selecting a working mode of the single-phase electric energy metering chip according to the result whether the main power supply is powered on;
the ADC sampling circuit is configured for sampling a current signal to obtain a digital signal;
the current effective value measuring circuit is configured for measuring a current effective value;
the judgment circuit for anti-tampering with neutral missing is configured for prejudging the digital signal to judge whether a current loop has a current, and if the current loop has a current, accurately judging the current effective value; and if the current effective value exceeds a threshold of anti-tampering with neutral missing, judging that it is necessary to perform metering of anti-tampering with neutral missing;
the electric energy metering circuit is configured for performing energy calculation on the current effective value to obtain an energy pulse; and
the clock circuit is configured for providing a clock source for the working mode control circuit, the ADC sampling circuit, the current effective value measurement circuit, the judgment circuit for anti-tampering with neutral missing and the electric energy metering circuit.

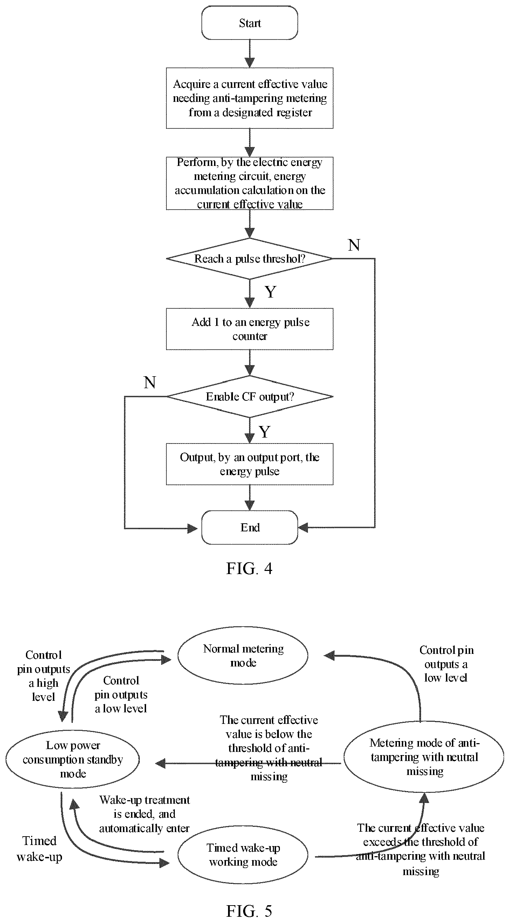

As shown in FIG. 5, the working mode comprises a normal metering mode, a low power consumption standby mode, a timed wake-up working mode and a metering mode of anti-tampering with neutral missing. When the main power supply is powered on, like the working mode shown in FIG. 5, a control pin inputs a low level and the single-phase electric energy metering chip enters the normal metering mode; and when the main power supply is not powered on, like the working mode shown in FIG. 5, the control outputs a high level, the single-phase electric energy metering chip enters the low power consumption standby mode, the ADC sampling circuit, the current effective value measuring circuit and the judgment circuit for anti-tampering with neutral missing are in standby state, and the electric energy metering circuit is in a standby state or working state. The level description of the operating mode control pin in FIG. 5 is for illustration only, and an opposite logic may also be adopted during actual implementation. When switching from other modes to the normal metering mode, the main control chip first reads energy data from the single-phase electric energy metering chip, and then the single-phase electric energy metering chip reinitializes and reconfigures various parameters comprising the preset parameters.

According to the invention, the working mode control circuit comprises a working mode control pin, a control pin monitoring circuit, a low power consumption timer and a working mode switching circuit.

The working mode control pin is configured for being connected to the main control chip and receiving the control signal sent by the main control chip.

The control pin monitoring circuit is configured for monitoring the control signal, wherein when the main power supply is powered on, the single-phase electric energy metering chip enters the normal metering mode, and when the main power supply is not powered on, the single-phase electric energy metering chip enters the low power consumption standby mode. To prevent external interference, in this embodiment, internal analog or digital filtering is performed in the control pin monitoring circuit, and the internal analog may be capacitive filtering or RC filtering. A recommended filtering width is 10 ms, and a level duration exceeds 10 ms, which can be regarded as an effective control signal.

The low power consumption timer is configured for monitoring whether a timed wake-up period T is reached in the low power consumption standby mode, and waking up the single-phase electric energy metering chip to enter the timed wake-up working mode when the timed wake-up period T is reached; and the clock circuit provides a low frequency clock source for the low power consumption timer and the clock is a low-speed clock of 32,768 Hz. In order to further reduce the power consumption, the clock may also subject to frequency division.

The working mode switching circuit is configured for switching among the low power consumption standby mode, the timed wake-up working mode and the metering mode of anti-tampering with neutral missing.

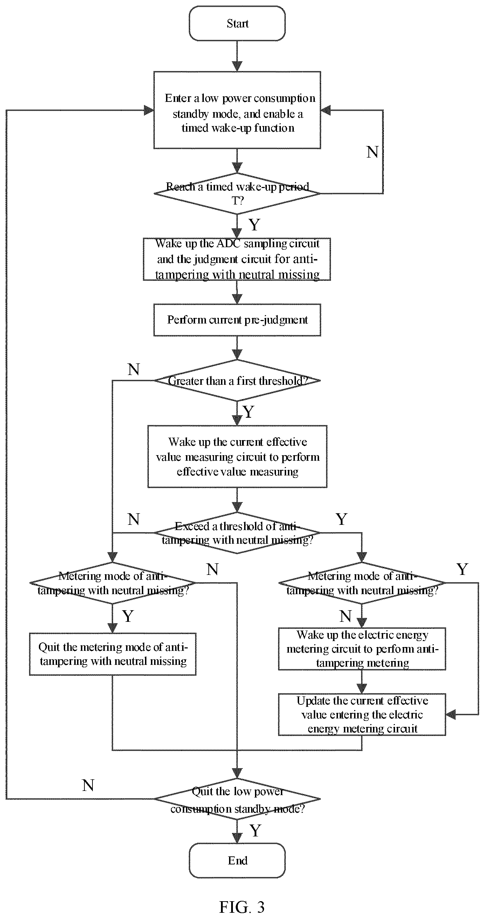

A flow chart of switching among the low power consumption standby mode, the timed wake-up working mode and the metering mode of anti-tampering with neutral missing is as shown in FIG. 3 and FIG. 4, comprising:
step 1: configuring, by the main control chip, preset parameters, wherein the preset parameters comprise:
   the timed wake-up period T for switching from the low power consumption standby mode to the timed wake-up working mode, wherein the maximum recommended timed wake-up period T is 60 seconds; and
   a working clock frequency of the ADC sampling circuit, a working clock frequency of the judgment circuit for anti-tampering with neutral missing, a working clock frequency of the current effective value measuring circuit and a working clock frequency of the electric energy metering circuit after entering the timed wake-up working mode;
step 2: entering, by the single-phase electric energy metering chip, the timed wake-up working mode to wake up the ADC sampling circuit and the judgment circuit for anti-tampering with neutral missing under the low power consumption standby mode when the timed wake-up period T is reached;
step 3: sampling, by the ADC sampling circuit, the current signal to obtain the digital signal; and pre-judging, by the judgment circuit for anti-tampering with neutral missing, the digital signal to judge whether the current loop has a current; adopting, by the ADC sampling circuit, a high frequency clock as the clock source;
step 4: if the current loop does not have a current, quitting the timed wake-up working mode and re-entering the low power consumption standby mode; and if the current loop has a current, waking up the current effective value measuring circuit to measure the current effective value; and adopting, by the current effective value measuring circuit, a high frequency clock as the clock source; wherein, the current effective value obtained by measuring may be saved in a designated register;
step 5: accurately judging, by the judgment circuit for anti-tampering with neutral missing, the current effective value, if the current effective value is below the threshold of anti-tampering with neutral missing, and the single-phase electric energy metering chip is also in the metering mode of anti-tampering with neutral missing at the moment, entering, by the electric energy metering circuit, the standby state, quitting the metering mode of anti-tampering with neutral missing and the timed wake-up working mode, and entering the low power consumption standby mode; if the single-phase electric energy metering chip is not in the metering mode of anti-tampering with neutral missing at the moment, quitting the timed wake-up working mode and entering the low power consumption standby mode; and after entering the low power consumption standby mode, repeating step 2; and
   if the current effective value exceeds the threshold of anti-tampering with neutral missing, and the single-phase electric energy metering chip is in the metering mode of anti-tampering with neutral missing, performing step 6; otherwise, waking up the electric energy metering circuit to enter the metering mode of anti-tampering with neutral missing to perform 6; wherein the threshold of anti-tampering with neutral missing is set according to the design and actual use requirements of the metering chip. For example, if the electric energy meter requires to enter the metering mode of anti-tampering with neutral missing when there is a current of 0.5 A, then according to the design principle of the metering chip and parameters of an external sampling circuit, the effective current value corresponding to 0.5 A is Irms by calculating, and this value is the threshold of anti-tampering with neutral missing; and
step 6: performing, by the electric energy metering circuit, energy accumulation calculation on the current effective value to obtain the energy pulse; and keeping, by the single-phase electric energy metering chip, the metering mode of anti-tampering with neutral missing, which means that the electric energy metering circuit being in the working mode and the single-phase electric energy metering chip entering the low power consumption standby mode at the same time, and repeating step 2.

In the metering mode of anti-tampering with neutral missing, the timed wake-up working mode and the low power consumption standby mode also exist at the same time. When a current is detected in the timed wake-up working mode, the electric energy metering circuit is enabled (in this case, the metering of anti-tampering with neutral missing is performed, and the low frequency clock is adopted to reduce the power consumption), and the electric energy metering circuit keeps working after being enabled. Then, the single-phase electric energy metering chip enters the low power consumption standby mode again to repeat step 2, and enters the timed wake-up working mode again when reaching the timed wake-up period T, and executes step 3 to step 5 to make judgment on anti-tampering with neutral missing; if the newly measured current effective value exceeds the threshold of anti-tampering with neutral missing, the newly measured current effective value is given to the electric energy metering circuit; if the newly measured current effective value is below the threshold of anti-tampering with neutral missing, the electric energy metering circuit enters the standby state, and then enters the low power consumption standby mode again.

In this embodiment, the pre-judging, by the judgment circuit for anti-tampering with neutral missing, the digital signal to judge whether the current loop has a current in step 3 comprises:
if sampling values of more than n continuous sampling points of the digital signal exceed a first threshold V within half cycle time, determining that a current passes through the current loop; otherwise, determining that no current passes through the current loop, wherein a value of n is set according to a number N of sampling points of the digital signal within one cycle time and the first threshold value V, and usually in a value range of N/4 to N/8; and
adopting, by the judgment circuit for anti-tampering with neutral missing, a high frequency clock as the clock source.

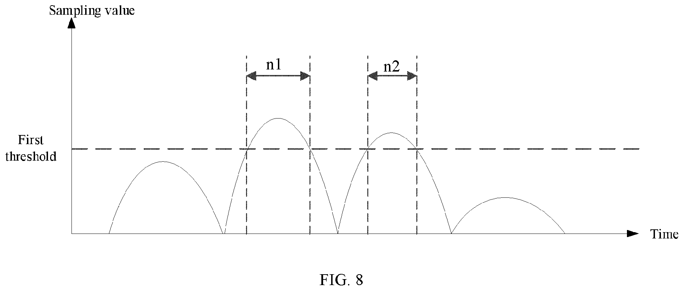

If it is required to enter the metering mode of anti-tampering with neutral missing when the current is greater than 0.5 A, and maximum sampling amplitude of the ADC is Vp when 0.5 A is calculated according to the circuit design, it is recommended to set the first threshold value V for pre-judgment as Vp/2. A power grid frequency is usually 50 Hz, and a sampling frequency of the ADC sampling circuit is 128 sampling points per cycle, i.e., N=128. If a preset number n of sampling points with present sampling values exceeding the first threshold V is 16, in the half cycle sampling period of 10 ms, if the sampling values of more than 16 sampling points in 64 sampling points are greater than the first threshold V, it is considered that the current loop has a current, such as n1 in FIG. 8; and if the sampling values of less than 16 sampling points are greater than the first threshold V, it is considered that the current loop has no current, such as n2 in FIG. 8. Although the pre-judgment accuracy is not high, the results are output quickly, and judgment can be made basically in half cycle.

The first threshold and the threshold of anti-tampering with neutral missing above may be set in step 1.

In this embodiment, the performing, by the electric energy metering circuit, energy accumulation calculation on the current effective value to obtain the energy pulse in step 6, is as shown in FIG. 4, comprising:
step 6.1: acquiring the current effective value needing metering of electricity stealing prevention from a designated register and performing energy accumulation calculation on the current effective value to obtain energy data; and
step 6.2: judging whether the energy data reach a pulse threshold TH_{CF}, and if the energy data do not reach the pulse threshold TH_{CF}, continuing step 6.1; and
if the energy data reach the pulse threshold TH_{CF}, adding 1 to an energy pulse counter; if a CF output function is in an enabled state, outputting, by an output port, the energy pulse to the main control chip, and subtracting the pulse threshold Th_{CF} from the energy data at the same time, and then continuing step 6.1. In this case, if the CF output function is in a disabled state, the main control chip may read a value of the energy pulse counter through the communication interface to obtain a number of CF pulses to perform energy accumulation.

Energy pulse is an output mode of electric energy commonly used in the electric energy metering chips, which is related to a pulse constant on a nameplate of the electric energy meter. For example, if the pulse constant is 1,200 imp/kWh, it means that every 1,200 pulses represent 1 kWh of electricity quantity (commonly referred to as 1 kWh of electricity). That is, when the accumulated electric energy reaches an electricity quantity of 1/1200 kWh, that is, Th_{CF}= 1/1,200 kWh, one electric energy pulse (CF) is generated.

In this embodiment, in the metering mode of anti-tampering with neutral missing in step 6, the electric energy metering circuit adopts a low frequency clock as the clock source. In the normal metering mode, the electric energy metering circuit adopts a high frequency clock as the clock source.

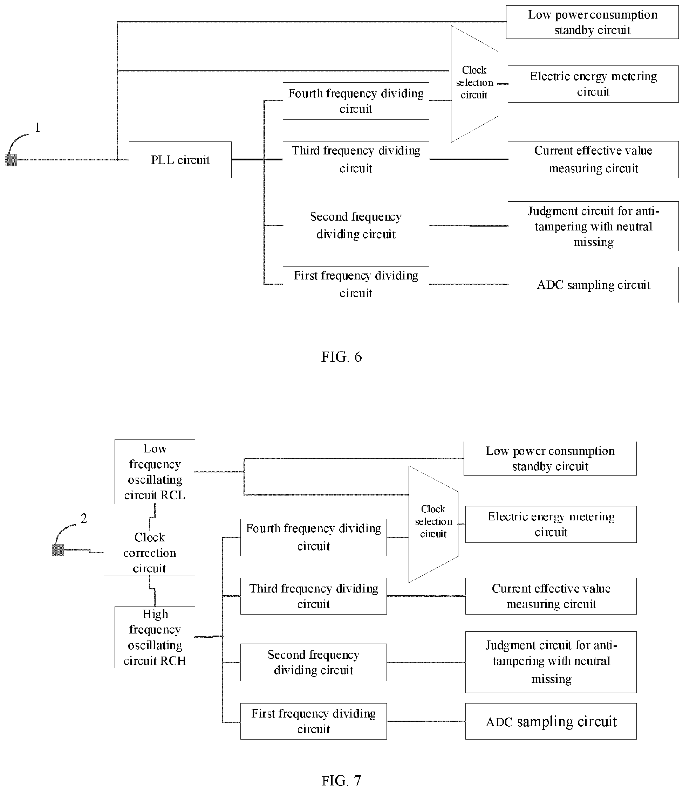

In this embodiment, the clock circuit may be implemented in the following ways, comprising, but not limited to: as shown in FIG. 6, in the first implementation manner, the clock circuit comprises a low frequency clock signal input pin 1, a PLL circuit, a clock selection circuit, a first frequency dividing circuit, a second frequency dividing circuit, a third frequency dividing circuit and a fourth frequency dividing circuit, and there are also other circuits in the clock circuit of the single-phase electric energy metering chip, which belong to the prior art, and are not limited in the embodiment of the present invention here.

An input end of the low frequency clock signal input pin 1 inputs a low frequency clock, a first output end of the low frequency clock signal input pin 1 is connected with a low power consumption standby circuit, a second output end of the low frequency clock signal input pin 1 is connected with a first input end of the clock selection circuit, and a third output end of the low frequency clock signal input pin 1 is connected with an input end of the PLL circuit; when a low frequency clock is input to the input end of the low frequency clock signal input pin 1, a low frequency crystal oscillator (generally a crystal oscillator of 32,768 Hz) may be externally connected, or a clock signal of 32,768 Hz may be directly input.

A first output end of the PLL circuit is connected with an input end of the first frequency dividing circuit, a second output end of the PLL circuit is connected with an input end of the second frequency dividing circuit, a third output end of the PLL circuit is connected with an input end of the third frequency dividing circuit, and a fourth output end of the PLL circuit is connected with an input end of the fourth frequency dividing circuit;
an output end of the first frequency dividing circuit is connected with the ADC sampling circuit, an output end of the second frequency dividing circuit is connected with the judgment circuit for anti-tampering with neutral missing, an output end of the third frequency dividing circuit is connected with the current effective value measuring circuit, and an output end of the fourth frequency dividing circuit is connected with a second input end of the clock selection circuit; and
an output end of the clock selection circuit is connected with the electric energy metering circuit, when the working mode of the single-phase electric energy metering chip is the normal metering mode, the clock selection circuit outputs the high frequency clock, and when the working mode of the single-phase electric energy metering chip is the metering mode of anti-tampering with neutral missing, the clock selection circuit outputs the low frequency clock.

As shown in FIG. 7, in the second implementation manner, the clock circuit comprises a communication port 2, a clock correction circuit, a low frequency oscillating circuit, a high frequency oscillating circuit, a clock selection circuit, a first frequency dividing circuit, a second frequency dividing circuit, a third frequency dividing circuit and a fourth frequency dividing circuit.

An input end of the communication port 2 inputs training bytes sent by the main control chip, an output end of the communication port 2 is connected with an input end of the clock correction circuit, a first output end of the clock correction circuit is connected with an input end of the low frequency oscillating circuit, and a second output end of the clock correction circuit is connected with an input end of the high frequency oscillating circuit. The communication port 2 is a direct communication interface between the single-phase electric energy metering chip and the main control chip MCU, which comes with the single-phase electric energy metering chip, and is generally a UART (Universal Asynchronous Receiver/Transmitter) interface, but through a special frame header design, the single-phase electric energy metering chip may also use this communication interface to correct clocks of the internal high frequency oscillating circuit RCH (high frequency oscillating circuit composed of a resistor R and a capacitor C) and the low frequency oscillating circuit RCL (low frequency oscillating circuit composed of a resistor R and a capacitor C). Please refer to patent CN104850170B Crystal-free Metering SoC Chip and Clock Acquisition Method thereof for the method of correcting the low frequency oscillating circuit RCL and the high frequency oscillating circuit RCH by the clock correction circuit.

A first output end of the low frequency oscillating circuit is connected with the low power consumption standby circuit, and an second output end of the low frequency oscillating circuit is connected with the first input end of the clock selection circuit;
a first output end of the high frequency oscillating circuit is connected with an input end of the first frequency dividing circuit, a second output end of the high frequency oscillating circuit is connected with an input end of the second frequency dividing circuit, a third output end of the high frequency oscillating circuit is connected with an input end of the third frequency dividing circuit, and a fourth output end of the high frequency oscillating circuit is connected with an input end of the fourth frequency dividing circuit;
an output end of the first frequency dividing circuit is connected with the ADC sampling circuit, an output end of the second frequency dividing circuit is connected with the judgment circuit for anti-tampering with neutral missing, an output end of the third frequency dividing circuit is connected with the current effective value measuring circuit, and an output end of the fourth frequency dividing circuit is connected with a second input end of the clock selection circuit; and
an output end of the clock selection circuit is connected with the electric energy metering circuit, when the working mode of the single-phase electric energy metering chip is the normal metering mode, the clock selection circuit outputs the high frequency clock, and when the working mode of the single-phase electric energy metering chip is the metering mode of anti-tampering with neutral missing, the clock selection circuit outputs the low frequency clock.

In this embodiment, the preset parameters in step 1 further comprise a measuring object of the current effective value measuring circuit, and the measuring object comprises simultaneous measurement of two current effective values of a live wire and a neutral wire, or measurement of either the current effective value of the live wire or the current effective value of the neutral wire; when the simultaneous measurement of the two current effective values of the live wire and the neutral wire is selected as the measuring object, after the waking up the current effective value measuring circuit to measure the current effective value in step 4, a large current effective value is selected to perform step 5 and step 6; and
if the current loop has a current in step 4, the current effective value measuring circuit is waken up to measure the current effective value after waiting for a time T1, wherein the time T1 is usually 10 ms; and after the current effective value is measured, an ADC module and the current effective value measuring circuit enter the standby state.

The present invention provides an idea and a method for the single-phase electric energy metering chip capable of realizing anti-tampering with neutral missing. There are many methods and ways to realize the technical solutions. The above is only the detailed embodiments of the present invention. It should be pointed out that those of ordinary skills in the art can make some improvements and embellishments without departing from the scope of the present invention, which is defined by the appended claims. All the unspecified components in the embodiments can be realized by the prior art.

## Claims

1. A single-phase electric energy metering chip capable of realizing anti-tampering with neutral missing, comprising a working mode control circuit, an ADC sampling circuit, a current effective value measuring circuit, a judgment circuit for anti-tampering with neutral missing, an electric energy metering circuit and a clock circuit, wherein:
the working mode control circuit is configured for being connected to a main control chip, receiving a control signal which is configured for judging whether a main power supply is powered on and sent by the main control chip, and selecting a working mode of the single-phase electric energy metering chip according to the result whether the main power supply is powered on;
the ADC sampling circuit is configured for sampling a current signal to obtain a digital signal;
the current effective value measuring circuit is configured for measuring a current effective value;
the judgment circuit for anti-tampering with neutral missing is configured for pre-judging the digital signal to judge whether a current loop has a current, and if the current loop has a current, accurately judging the current effective value; and if the current effective value exceeds a threshold of anti-tampering with neutral missing, judging that it is necessary to perform metering of anti-tampering with neutral missing;
the electric energy metering circuit is configured for performing energy calculation on the current effective value to obtain an energy pulse; and
the clock circuit is configured for providing a clock source for the working mode control circuit, the ADC sampling circuit, the current effective value measurement circuit, the judgment circuit for anti-tampering with neutral missing and the electric energy metering circuit,
wherein the working mode comprises a normal metering mode, a low power consumption standby mode, a timed wake-up working mode and a metering mode of anti-tampering with neutral missing;
when the main power supply is powered on, the single-phase electric energy metering chip enters the normal metering mode; and
when the main power supply is not powered on, the single-phase electric energy metering chip enters the low power consumption standby mode, and under the low power consumption standby mode, the ADC sampling circuit, the current effective value measuring circuit and the judgment circuit for anti-tampering with neutral missing are in standby state, and the electric energy metering circuit is in a standby state or working state,
wherein the working mode control circuit comprises a working mode control pin, a control pin monitoring circuit, a low power consumption timer and a working mode switching circuit,
the working mode control pin is configured for being connected to the main control chip and receiving the control signal sent by the main control chip;
the control pin monitoring circuit is configured for monitoring the control signal, wherein when the main power supply is powered on, the single-phase electric energy metering chip enters the normal metering mode, and when the main power supply is not powered on, the single-phase electric energy metering chip enters the low power consumption standby mode;
the low power consumption timer is configured for monitoring whether a timed wake-up period T is reached in the low power consumption standby mode, and waking up the single-phase electric energy metering chip to enter the timed wake-up working mode when the timed wake-up period T is reached; and the clock circuit provides a low frequency clock source for the low power consumption timer; and
the working mode switching circuit is configured for switching among the low power consumption standby mode, the timed wake-up working mode and the metering mode of anti-tampering with neutral missing, wherein the switching among the low power consumption standby mode, the timed wake-up working mode and the metering mode of anti-tampering with neutral missing comprises:
step 1: configuring, by the main control chip, preset parameters, wherein the preset parameters comprise:
the timed wake-up period T for switching from the low power consumption standby mode to the timed wake-up working mode; and
a working clock frequency of the ADC sampling circuit, a working clock frequency of the judgment circuit for anti-tampering with neutral missing, a working clock frequency of the current effective value measuring circuit and a working clock frequency of the electric energy metering circuit after entering the timed wake-up working mode;
step 2: entering, by the single-phase electric energy metering chip, the timed wake-up working mode to wake up the ADC sampling circuit and the judgment circuit for anti-tampering with neutral missing under the low power consumption standby mode when the timed wake-up period T is reached;
step 3: sampling, by the ADC sampling circuit, the current signal to obtain the digital signal; and pre-judging, by the judgment circuit for anti-tampering with neutral missing, the digital signal to judge whether the current loop has a current;
step 4: if the current loop does not have a current, quitting the timed wake-up working mode and re-entering the low power consumption standby mode; and if the current loop has a current, waking up the current effective value measuring circuit to measure the current effective value;
step 5: accurately judging, by the judgment circuit for anti-tampering with neutral missing, the current effective value, if the current effective value is below the threshold of anti-tampering with neutral missing, and the single-phase electric energy metering chip is also in the metering mode of anti-tampering with neutral missing at the moment, entering, by the electric energy metering circuit, the standby state, quitting the metering mode of anti-tampering with neutral missing and the timed wake-up working mode, and entering the low power consumption standby mode; if the single-phase electric energy metering chip is not in the metering mode of anti-tampering with neutral missing at the moment, quitting the timed wake-up working mode and entering the low power consumption standby mode; and after entering the low power consumption standby mode, repeating step 2; and
if the current effective value exceeds the threshold of anti-tampering with neutral missing, and the single-phase electric energy metering chip is in the metering mode of anti-tampering with neutral missing, performing step 6; otherwise, waking up the electric energy metering circuit to enter the metering mode of anti-tampering with neutral missing to perform 6; and
step 6: performing, by the electric energy metering circuit, energy accumulation calculation on the current effective value to obtain the energy pulse; and keeping, by the single-phase electric energy metering chip, the metering mode of anti-tampering with neutral missing, which means that the electric energy metering circuit being in the working mode and the single-phase electric energy metering chip entering the low power consumption standby mode at the same time, and repeating step 2.

2. The single-phase electric energy metering chip capable of anti-tampering with neutral missing according to claim1, wherein the pre-judging, by the judgment circuit for anti-tampering with neutral missing, the digital signal to judge whether the current loop has a current in step 3 comprises:
if sampling values of more than n continuous sampling points of the digital signal exceed a first threshold V within half cycle time, determining that a current passes through the current loop; otherwise, determining that no current passes through the current loop, wherein a value of n is set according to a number N of sampling points of the digital signal within one cycle time and the first threshold value V; and
adopting, by the judgment circuit for anti-tampering with neutral missing, a high frequency clock as the clock source.

3. The single-phase electric energy metering chip capable of realizing anti-tampering with neutral missing according to claim 2, wherein the performing, by the electric energy metering circuit, energy accumulation calculation on the current effective value to obtain the energy pulse in step 6 comprises:
step 6.1: performing energy accumulation calculation on the current effective value to obtain energy data; and
step 6.2: judging whether the energy data reach a pulse threshold TH_{CF}, and if the energy data do not reach the pulse threshold TH_{CF}, continuing step 6.1; and
if the energy data reach the pulse threshold TH_{CF}, adding 1 to an energy pulse counter; if a CF output function is in an enabled state, outputting, by an output port, the energy pulse to the main control chip, and subtracting the pulse threshold Th_{CF} from the energy data at the same time, and then continuing step 6.1.

4. The single-phase electric energy metering chip capable of realizing anti-tampering with neutral missing according to claim 3, wherein in the metering mode of anti-tampering with neutral missing in step 6, the electric energy metering circuit adopts a low frequency clock as the clock source.

5. The single-phase electric energy metering chip capable of realizing anti-tampering with neutral missing according to claim 4, wherein the clock circuit comprises a low frequency clock signal input pin (1), a PLL circuit, a clock selection circuit, a first frequency dividing circuit, a second frequency dividing circuit, a third frequency dividing circuit and a fourth frequency dividing circuit,
an input end of the low frequency clock signal input pin (1) inputs a low frequency clock, a first output end of the low frequency clock signal input pin (1) is connected with a low power consumption standby circuit, a second output end of the low frequency clock signal input pin (1) is connected with a first input end of the clock selection circuit, and a third output end of the low frequency clock signal input pin (1) is connected with an input end of the PLL circuit;
a first output end of the PLL circuit is connected with an input end of the first frequency dividing circuit, a second output end of the PLL circuit is connected with an input end of the second frequency dividing circuit, a third output end of the PLL circuit is connected with an input end of the third frequency dividing circuit, and a fourth output end of the PLL circuit is connected with an input end of the fourth frequency dividing circuit;
an output end of the first frequency dividing circuit is connected with the ADC sampling circuit, an output end of the second frequency dividing circuit is connected with the judgment circuit for anti-tampering with neutral missing, an output end of the third frequency dividing circuit is connected with the current effective value measuring circuit, and an output end of the fourth frequency dividing circuit is connected with a second input end of the clock selection circuit; and
an output end of the clock selection circuit is connected with the electric energy metering circuit, when the working mode of the single-phase electric energy metering chip is the normal metering mode, the clock selection circuit outputs the high frequency clock, and when the working mode of the single-phase electric energy metering chip is the metering mode of anti-tampering with neutral missing, the clock selection circuit outputs the low frequency clock.

6. The single-phase electric energy metering chip capable of realizing anti-tampering with neutral missing according to claim 5, wherein the clock circuit comprises a communication port (2), a clock correction circuit, a low frequency oscillating circuit, a high frequency oscillating circuit, a clock selection circuit, a first frequency dividing circuit, a second frequency dividing circuit, a third frequency dividing circuit and a fourth frequency dividing circuit,
an input end of the communication port (2) inputs training bytes sent by the main control chip, an output end of the communication port (2) is connected with an input end of the clock correction circuit, a first output end of the clock correction circuit is connected with an input end of the low frequency oscillating circuit, and a second output end of the clock correction circuit is connected with an input end of the high frequency oscillating circuit;
a first output end of the low frequency oscillating circuit is connected with the low power consumption standby circuit, and an second output end of the low frequency oscillating circuit is connected with the first input end of the clock selection circuit;
a first output end of the high frequency oscillating circuit is connected with an input end of the first frequency dividing circuit, a second output end of the high frequency oscillating circuit is connected with an input end of the second frequency dividing circuit, a third output end of the high frequency oscillating circuit is connected with an input end of the third frequency dividing circuit, and a fourth output end of the high frequency oscillating circuit is connected with an input end of the fourth frequency dividing circuit;
an output end of the first frequency dividing circuit is connected with the ADC sampling circuit, an output end of the second frequency dividing circuit is connected with the judgment circuit for anti-tampering with neutral missing, an output end of the third frequency dividing circuit is connected with the current effective value measuring circuit, and an output end of the fourth frequency dividing circuit is connected with a second input end of the clock selection circuit; and
an output end of the clock selection circuit is connected with the electric energy metering circuit, when the working mode of the single-phase electric energy metering chip is the normal metering mode, the clock selection circuit outputs the high frequency clock, and when the working mode of the single-phase electric energy metering chip is the metering mode of anti-tampering with neutral missing, the clock selection circuit outputs the low frequency clock.

7. The single-phase electric energy metering chip capable of realizing anti-tampering with neutral missing according to claim 5 or 6, wherein the preset parameters in step 1 further comprise a measuring object of the current effective value measuring circuit, and the measuring object comprise simultaneous measurement of two current effective values of a live wire and a neutral wire, or measurement of either the current effective value of the live wire or the current effective value of the neutral wire; when the simultaneous measurement of the two current effective values of the live wire and the neutral wire is selected as the measuring object, after the waking up the current effective value measuring circuit to measure the current effective value in step 4, a large current effective value is selected to perform step 5 and step 6; and
if the current loop has a current in step 4, the current effective value measuring circuit is waken up to measure the current effective value after waiting for a time T1; and after the current effective value is measured, an ADC module and the current effective value measuring circuit enter the standby state.

## Patentansprüche

1. Einphasiger elektrischer Energiemessungschip mit der Fähigkeit zur Realisierung eines Verfälschungsschutzes bei fehlendem Neutralleiter, umfassend einen Arbeitsmodus-Steuerschaltkreis, einen ADU-Abtastschaltkreis, einen Messschaltkreis für einen effektiven Stromwert, einen Beurteilungsschaltkreis zum Verfälschungsschutz bei fehlendem Neutralleiter, einen elektrischen Energiemessschaltkreis und einen Taktschaltkreis, wobei folgendes gilt:
der Arbeitsmodus-Steuerschaltkreis ist gestaltet für eine Verbindung mit einem Hauptsteuerchip, den Empfang eines Steuersignals, das gestaltet ist zur Beurteilung, ob eine Hauptenergieversorgung eingeschaltet ist und durch den Hauptsteuerchip gesendet worden ist, und zur Auswahl eines Arbeitsmodus des einphasigen elektrischen Energiemessungschips gemäß dem Ergebnis, ob die Hauptenergieversorgung eingeschaltet ist;
der ADU-Abtastschaltkreis ist gestaltet zum Abtasten eines Stromsignals, um ein digitales Signal zu erhalten;
der Messschaltkreis für einen effektiven Stromwert ist zum Messen eines effektiven Stromwertes gestaltet;
der Beurteilungsschaltkreis zum Verfälschungsschutz bei fehlendem Neutralleiter ist gestaltet zur Vorabbeurteilung des digitalen Signals, um zu Beurteilen, ob eine Stromschleife Strom führt, und sofern die Stromschleife einen Strom führt, zur präzisen Beurteilung des effektiveb Stromwerts; und sofern der effektive Stromwert einen Schwellenwert für den Verfälschungsschutz bei fehlendem Neutralleiter überschreitet, zur Beurteilung, dass es erforderlich ist, eine Messung des Verfälschungsschutzes bei fehlendem Neutralleiter durchzuführen;
der elektrische Energiemessschaltkreis ist gestaltet zur Durchführung einer Energieberechnung an dem effektiven Stromwert, um einen Energieimpuls zu erhalten; und
der Taktschaltkreis ist gestaltet zur Bereitstellung einer Taktquelle für den Arbeitsmodus-Steuerschaltkreis, den ADU-Abtastschaltkreis, den Messschaltkreis für den effektiven Stromwert, den Beurteilungsschaltkreis zum Verfälschungsschutz bei fehlendem Neutralleiter und den elektrischen Energiemessschaltkreis,
wobei der Arbeitsmodus einen normalen Messmodus, einen Standby-Modus mit geringem Energieverbrauch, einen zeitgesteuerten Aufwach-Arbeitsmodus und einen Messmodus für Verfälschungsschutz bei fehlendem Neutralleiter umfasst;
wobei, wenn die Hauptenergieversorgung eingeschaltet wird, der einphasige elektrische Energiemessungschip in den normalen Messmodus eintritt; und
wobei, wenn die Hauptenergieversorgung nicht eingeschaltet wird, der einphasige elektrische Energiemessungschip in den Standby-Modus mit geringem Energieverbrauch eintritt, und wobei sich in dem Standby-Modus mit geringem Energieverbrauch der ADU-Abtastschaltkreis, der Messschaltkreis für einen effektiven Stromwert und der Beurteilungsschaltkreis zum Verfälschungsschutz bei fehlendem Neutralleiter in dem Standby-Zustand befinden, und wobei sich der elektrische Energiemessschaltkreis in einem Standby-Zustand oder Arbeitszustand befindet,
wobei der Arbeitsmodus-Steuerschaltkreis einen Arbeitsmodus-Steuerpin, einen Steuerpin-Überwachungsschaltkreis, einen Timer für geringen Energieverbrauch und einen Arbeitsmodus-Umschaltschaltkreis umfasst,
der Arbeitsmodus-Steuerpin ist gestaltet für eine Verbindung mit dem Hauptsteuerchip und für den Empfang des von dem Hauptsteuerchip gesendeten Steuersignals;
der Steuerpin-Überwachungsschaltkreis ist zur Überwachung des Steuersignals gestaltet, wobei, wenn die Hauptenergieversorgung eingeschaltet wird, der einphasige elektrische Energiemessungschip in den normalen Messmodus eintritt, und wobei, wenn die Hauptenergieversorgung nicht eingeschaltet wird, der einphasige elektrische Energiemessungschip in den Standby-Modus mit geringem Energieverbrauch eintritt;
der Timer für geringen Energieverbrauch ist gestaltet zur Überwachung, ob ein zeitgesteuerter Aufwachzeitraum T in dem Standby-Modus mit geringem Energieverbrauch erreicht ist, und zum Aufwecken des einphasigen elektrischen Energiemessungschips zum Eintritt in den zeitgesteuerten Aufwach-Arbeitsmodus, wenn der zeitgesteuerte Aufwachzeitraum T erreicht ist, und der Taktschaltkreis stellt eine Niederfrequenz-Taktquelle für den Timer für geringen Energieverbrauch bereit; und
der Arbeitsmodus-Umschaltschaltkreis ist gestaltet zum Umschalten zwischen dem Standby-Modus mit geringem Energieverbrauch, dem zeitgesteuerten Aufwach-Arbeitsmodus und dem Messmodus für Verfälschungsschutz bei fehlendem Neutralleiter, wobei das Umschalten zwischen dem Standby-Modus mit geringem Energieverbrauch, dem zeitgesteuerten Aufwach-Arbeitsmodus und dem Messmodus für Verfälschungsschutz bei fehlendem Neutralleiter folgendes umfasst:
Schritt 1: durch den Hauptsteuerchip, Konfigurieren voreingestellter Parameter, wobei die voreingestellten Parameter folgendes umfassen:
den zeitgesteuerten Aufwachzeitraum T zum Umschalten aus dem Standby-Modus mit geringem Energieverbrauch in den zeitgesteuerten Aufwach-Arbeitsmodus; und
eine Arbeitstaktfrequenz des ADU-Abtastschaltkreises, eine Arbeitstaktfrequenz des Beurteilungsschaltkreises zum Verfälschungsschutz bei fehlendem Neutralleiter, eine Arbeitstaktfrequenz des Messschaltkreises für einen effektiven Stromwert und eine Arbeitstaktfrequenz des elektrischen Energiemessschaltkreises nach dem Eintritt in den zeitgesteuerten Aufwach-Arbeitsmodus;
Schritt 2: durch den einphasigen elektrischen Energiemessungschip, Eintreten in den zeitgesteuerten Aufwach-Arbeitsmodus, um den ADU-Abtastschaltkreis und den Beurteilungsschaltkreis zum Verfälschungsschutz bei fehlendem Neutralleiter im Standby-Modus mit geringem Energieverbrauch aufzuwecken, wenn der zeitgesteuerte Aufwachzeitraum T erreicht ist;
Schritt 3: durch den ADU-Abtastschaltkreis, Abtasten des Stromsignals, um das digitale Signal zu erhalten; und durch den Beurteilungsschaltkreis zum Verfälschungsschutz bei fehlendem Neutralleiter, Vorabbeurteilen des digitalen Signals, um zu beurteilen, ob die Stromschleife einen Strom führt;
Schritt 4: wenn die Stromschleife keinen Strom führt, Beenden des zeitgesteuerten Aufwach-Arbeitsmodus und Wiedereintreten in den Standby-Modus mit geringem Energieverbrauch; und wenn die Stromschleife einen Strom führt, Aufwecken des Messschaltkreises für einen effektiven Stromwert, um den effektiven Stromwert zu messen;
Schritt 5: durch den Beurteilungsschaltkreis zum Verfälschungsschutz bei fehlendem Neutralleiter, präzises Beurteilen des effektiven Stromwerts, wenn der effektive Stromwert unterhalb des Schwellenwertes für den Verfälschungsschutz bei fehlendem Neutralleiter liegt, und wenn sich der einphasige elektrische Energiemessungschip in dem Augenblick ebenfalls in dem Messmodus für Verfälschungsschutz bei fehlendem Neutralleiter befindet, durch den elektrischen Energiemessschaltkreis, Eintreten in den Standby-Zustand, Beenden des Messmodus für Verfälschungsschutz bei fehlendem Neutralleiter und des zeitgesteuerten Aufwach-Arbeitsmodus, und Eintreten in den Standby-Modus mit geringem Energieverbrauch; und wenn sich der einphasige elektrische Energiemessungschip in dem Augenblick nicht in dem Messmodus für Verfälschungsschutz bei fehlendem Neutralleiter befindet, Beenden des zeitgesteuerten Aufwach-Arbeitsmodus und Eintreten in den Standby-Modus mit geringem Energieverbrauch; und nach dem Eintreten in den Standby-Modus mit geringem Energieverbrauch, Wiederholen von Schritt 2; und
wenn der effektive Stromwert den Schwellenwert für den Verfälschungsschutz bei fehlendem Neutralleiter überschreitet, und wenn sich der einphasige elektrische Energiemessungschip in dem Messmodus für Verfälschungsschutz bei fehlendem Neutralleiter befindet, Ausführen von Schritt 6; ansonsten, Aufwecken des elektrischen Energiemessschaltkreises, um in den Messmodus für Verfälschungsschutz bei fehlendem Neutralleiter einzutreten, um Schritt 6 auszuführen; und
Schritt 6: durch den elektrischen Energiemessschaltkreis, Ausführen einer Energieakkumulationsberechnung an dem effektiven Stromwert, um den Energieimpuls zu erhalten; und durch den einphasigen elektrischen Energiemessungschip, Aufrechterhalten des Messmodus für Verfälschungsschutz bei fehlendem Neutralleiter, was bedeutet, dass sich der elektrische Energiemessschaltkreis in dem Arbeitsmodus befindet und der einphasige elektrische Energiemessungschip gleichzeitig in den Standby-Modus mit geringem Energieverbrauch eintritt, und Wiederholen von Schritt 2.

2. Einphasiger elektrischer Energiemessungschip mit der Fähigkeit zur Realisierung eines Verfälschungsschutzes bei fehlendem Neutralleiter nach Anspruch 1, wobei das Vorabbeurteilen des digitalen Signals, um zu beurteilen, ob die Stromschleife einen Strom führt, durch den Beurteilungsschaltkreis zum Verfälschungsschutz bei fehlendem Neutralleiter in Schritt 3 folgendes umfasst:
wenn Abtastwerte von mehr als n zusammenhängenden Abtastpunkten des digitalin Signals in Halbzykluszeit einen ersten Schwellenwert V überschreiten, Bestimmen, dass ein Strom durch die Stromschleife fließt; ansonsten, Bestimmen, dass kein Strom durch die Stromschleife fließt, wobei ein Wert von n festgelegt wird gemäß einer Anzahl N von Abtastpunkten des digitalen Signals in einem Zykluszeitraum und dem ersten Schwellenwert V; und
durch den Beurteilungsschaltkreis zum Verfälschungsschutz bei fehlendem Neutralleiter Annehmen eines Hochfrequenztaktes als die Taktquelle.

3. Einphasiger elektrischer Energiemessungschip mit der Fähigkeit zur Realisierung eines Verfälschungsschutzes bei fehlendem Neutralleiter nach Anspruch 2, wobei das Ausführen einer Energieakkumulationsberechnung an dem effektiven Stromwert durch den elektrischen Energiemessschaltkreis, um den Energieimpuls zu erhalten, in Schritt 6 folgendes umfasst:
Schritt 6.1: Ausführen einer Energieakkumulationsberechnung an dem effektiven Stromwert, um Energiedaten zu erhalten; und
Schritt 6.2: Beurteilen, ob die Energiedaten einen Impulsschwellenwert Th_{CF} erreichen, und wenn die Energiedaten den Impulsschwellenwert Th_{CF} nicht erreichen, Fortfahren mit Schritt 6.1; und
wenn die Energiedaten den Impulsschwellenwert Th_{CF} erreichen, einen Energieimpulszähler um 1 erhöhen; wenn sich eine CF-Ausgangsfunktion in einem freigegebenen Zustand befindet, durch einen Ausgangsanschluss, Ausgeben des Energieimpulses an den Hauptsteuerchip, und gleichzeitiges Subtrahieren des Impulsschwellenwertes Th_{CF} von den Energiedaten, und Fortfahren mit Schritt 6.1.

4. Einphasiger elektrischer Energiemessungschip mit der Fähigkeit zur Realisierung eines Verfälschungsschutzes bei fehlendem Neutralleiter nach Anspruch 3, wobei in dem Messmodus für Verfälschungsschutz bei fehlendem Neutralleiter in Schritt 6 der elektrische Energiemessschaltkreis einen Niederfrequenztakt als die Taktquelle annimmt.

5. Einphasiger elektrischer Energiemessungschip mit der Fähigkeit zur Realisierung eines Verfälschungsschutzes bei fehlendem Neutralleiter nach Anspruch 4, wobei der Taktschaltkreis folgendes umfasst: einen Niederfrequenz-Taktsignal-Eingangspin (1), einen PLL-Schaltkreis, einen Taktauswahlschaltkreis, einen ersten Frequenzteilungsschaltkreis, einen zweiten Frequenzteilungsschaltkreis, einen dritten Frequenzteilungsschaltkreis und einen vierten Frequenzteilungsschaltkreis,
wobei ein Eingangsende des Niederfrequenz-Taktsignal-Eingangspins (1) einen Niederfrequenztakt eingibt, wobei ein erstes Ausgangsende des Niederfrequenz-Taktsignal-Eingangspins (1) mit einem Standby-Schaltkreis für geringen Energieverbrauch verbunden ist, wobei ein zweites Ausgangsende des Niederfrequenz-Taktsignal-Eingangspins (1) mit einem ersten Eingangsende des Taktauswahlschaltkreises verbunden ist, und wobei ein drittes Ausgangsende des Niederfrequenz-Taktsignal-Eingangspins (1) mit einem Eingangsende des PLL-Schaltkreises verbunden ist;
wobei ein erstes Ausgangsende des PLL-Schaltkreises mit einem Eingangsende des ersten Frequenzteilungsschaltkreises verbunden ist, wobei ein zweites Ausgangsende des PLL-Schaltkreises mit einem Eingangsende des zweiten Frequenzteilungsschaltkreises verbunden ist, wobei ein drittes Ausgangsende des PLL-Schaltkreises mit einem Eingangsende des dritten Frequenzteilungsschaltkreises verbunden ist, und wobei ein viertes Ausgangsende des PLL-Schaltkreises mit einem Eingangsende des vierten Frequenzteilungsschaltkreises verbunden ist; wobei ein Ausgangsende des ersten Frequenzteilungsschaltkreises mit dem ADU-Abtastschaltkreis verbunden ist;
wobei ein Ausgangsende des zweiten Frequenzteilungsschaltkreises mit dem Beurteilungsschaltkreis zum Verfälschungsschutz bei fehlendem Neutralleiter verbunden ist, wobei ein Ausgangsende des dritten Frequenzteilungsschaltkreises mit dem Messschaltkreis für einen effektiven Stromwert verbunden ist, und wobei ein Ausgangsende des vierten Frequenzteilungsschaltkreises mit einem zweiten Eingangsende des Taktauswahlschaltkreises verbunden ist; und
wobei ein Ausgangsende des Taktauswahlschaltkreises mit dem elektrischen Energiemessschaltkreis verbunden ist, wobei, wenn sich der Arbeitsmodus des einphasigen elektrischen Energiemessungschips in dem normalen Messmodus befindet, der Taktauswahlschaltkreis den Hochfrequenztakt ausgibt, und wenn sich der Arbeitsmodus des einphasigen elektrischen Energiemessungschips in dem Messmodus für Verfälschungsschutz bei fehlendem Neutralleiter befindet, gibt der Taktauswahlschaltkreis den Niederfrequenztakt aus.

6. Einphasiger elektrischer Energiemessungschip mit der Fähigkeit zur Realisierung eines Verfälschungsschutzes bei fehlendem Neutralleiter nach Anspruch 5, wobei der Taktschaltkreis folgendes umfasst: einen Kommunikationsanschluss (2), einen Taktkorrekturschaltkreis, einen Niederfrequenz-Oszillationsschaltkreis, einen Hochfrequenz-Oszillationsschaltkreis, einen Taktauswahlschaltkreis, einen ersten Frequenzteilungsschaltkreis, einen zweiten Frequenzteilungsschaltkreis, einen dritten Frequenzteilungsschaltkreis und einen vierten Frequenzteilungsschaltkreis,
wobei ein Eingangsende des Kommunikationsanschlusses (2) durch den Hauptspeicherchip gesendete Trainingsbytes eingibt, wobei ein Ausgangsende des Kommunikationsanschlusses (2) mit einem Eingangsende des Taktkorrekturschaltkreises verbunden ist, wobei ein erstes Ausgangsende des Taktkorrekturschaltkreises mit einem Eingangsende des Niederfrequenz-Oszillationsschaltkreises verbunden ist, und wobei ein zweites Ausgangsende des Taktkorrekturschaltkreises mit einem Eingangsende des Hochfrequenz-Oszillationsschaltkreises verbunden ist;
wobei ein erstes Ausgangsende des Niederfrequenz-Oszillationsschaltkreises mit dem Standby-Schaltkreis für geringen Energieverbrauch verbunden ist, und wobei ein zweites Ausgangsende des Niederfrequenz-Oszillationsschaltkreises mit dem ersten Eingangsende des Taktauswahlschaltkreises verbunden ist;
wobei ein erstes Ausgangsende des Hochfrequenz-Oszillationsschaltkreises mit einem Eingangsende des ersten Frequenzteilungsschaltkreises verbunden ist, wobei ein zweites Ausgangsende des Hochfrequenz-Oszillationsschaltkreises mit einem Eingangsende des zweiten Frequenzteilungsschaltkreises verbunden ist, wobei ein drittes Ausgangsende des Hochfrequenz-Oszillationsschaltkreises mit einem Eingangsende des dritten Frequenzteilungsschaltkreises verbunden ist, und wobei ein viertes Ausgangsende des Hochfrequenz-Oszillationsschaltkreises mit einem Eingangsende des vierten Frequenzteilungsschaltkreises verbunden ist;
wobei ein Ausgangsende des ersten Frequenzteilungsschaltkreises mit dem ADU-Abtastschaltkreis verbunden ist, wobei ein Ausgangsende des zweiten Frequenzteilungsschaltkreises mit dem Beurteilungsschaltkreis zum Verfälschungsschutz bei fehlendem Neutralleiter verbunden ist, wobei ein Ausgangsende des dritten Frequenzteilungsschaltkreises mit dem Messschaltkreis für einen effektiven Stromwert verbunden ist, und wobei ein Ausgangsende des vierten Frequenzteilungsschaltkreises mit einem zweiten Eingangsende des Taktauswahlschaltkreises verbunden ist; und
wobei ein Ausgangsende des Taktauswahlschaltkreises mit dem elektrischen Energiemessschaltkreis verbunden ist; wobei, wenn sich der Arbeitsmodus des einphasigen elektrischen Energiemessungschips in dem normalen Messmodus befindet, der Taktauswahlschaltkreis den Hochfrequenzmodus ausgibt, und wobei, wenn sich der Arbeitsmodus des einphasigen elektrischen Energiemessungschips in dem Messmodus für Verfälschungsschutz bei fehlendem Neutralleiter befindet, der Taktauswahlschaltkreis den Niederfrequenztakt ausgibt.

7. Einphasiger elektrischer Energiemessungschip mit der Fähigkeit zur Realisierung eines Verfälschungsschutzes bei fehlendem Neutralleiter nach Anspruch 5 oder 6, wobei die voreingestellten Parameter in Schritt 1 ferner ein Messziel des Messschaltkreises für einen effektiven Stromwert umfassen, und wobei das Messziel die gleichzeitige Messung von zwei effektiven Stromwerten eines stromführenden Drahtes und eines neutralen Drahtes umfasst, oder die Messung entweder effektiven Stromwertes des stromführenden Drahtes oder effektiven Stromwertes des neutralen Drahtes; wenn die gleichzeitige Messung der zwei effektiven Stromwerte des stromführenden Drahtes und des neutralen Drahtes als das Messziel ausgewählt ist, nach dem Aufwecken des Messschaltkreises für einen effektiven Stromwert zum Messen des effektiven Stromwertes in Schritt 4, wird für die Durchführung von Schritt 5 und Schritt 6 ein hoher effektiver Stromwert ausgewählt; und
wenn die Stromschleife in Schritt 4 einen Strom führt, wird der Messschaltkreis für einen effektiven Stromwert nach einer Wartezeit T1 aufgeweckt, um den effektiven Stromwert zu messen, und nachdem der effektive Stromwert gemessen worden ist, treten ein ADU-Modul und der Messschaltkreis für einen effektiven Stromwert in den Standby-Zustand ein.

## Revendications

1. Puce de mesure d'énergie électrique monophasée pour une application de prévention de vol d'électricité par dérivation de fil neutre, comprenant un circuit de commande de mode de fonctionnement, un circuit d'échantillonnage de CAN, un circuit de mesure de valeur effective de courant, un circuit de détermination de vol d'électricité par dérivation de fil neutre, un circuit de mesure d'énergie électrique et un circuit d'horloge,
le circuit de commande de mode de fonctionnement étant conçu pour être connecté à une puce de commande principale, recevoir un signal de commande conçu pour déterminer si une alimentation principale est sous tension et envoyé par la puce de commande principale, et sélectionner un mode de fonctionnement de la puce de mesure d'énergie électrique monophasée en fonction du résultat indiquant si l'alimentation principale est sous tension ;
le circuit d'échantillonnage de CAN étant conçu pour échantillonner un signal de courant afin d'obtenir un signal numérique ;
le circuit de mesure de valeur effective de courant étant conçu pour mesurer une valeur effective de courant ;
le circuit de détermination de vol d'électricité par dérivation de fil neutre étant conçu pour pré-déterminer le signal numérique afin de déterminer s'il y a du courant dans une boucle de courant, et s'il y a du courant dans la boucle de courant, déterminer avec précision la valeur effective de courant ; et si la valeur effective de courant dépasse un seuil de prévention de vol d'électricité par dérivation de fil neutre, déterminer qu'il est nécessaire d'effectuer une mesure de prévention de vol d'électricité par dérivation de fil neutre ;
le circuit de mesure d'énergie électrique étant conçu pour effectuer un calcul d'énergie sur la valeur effective de courant afin d'obtenir une impulsion d'énergie ; et
le circuit d'horloge étant conçu pour fournir une source d'horloge au circuit de commande de mode de fonctionnement, au circuit d'échantillonnage de CAN, au circuit de mesure de valeur effective de courant, au circuit de détermination de vol d'électricité par dérivation de fil neutre et au circuit de mesure d'énergie électrique,
le mode de fonctionnement comprenant un mode de mesure normal, un mode de veille à faible consommation d'énergie, un mode de fonctionnement à réveil programmé et un mode de mesure de prévention de vol d'électricité par dérivation de fil neutre ;
lorsque l'alimentation principale est mise sous tension, la puce de mesure d'énergie électrique monophasée passe en mode de mesure normal ; et
lorsque l'alimentation principale n'est pas sous tension, la puce de mesure d'énergie électrique monophasée passant en mode de veille à faible consommation d'énergie, et en mode de veille à faible consommation d'énergie, le circuit d'échantillonnage de CAN, le circuit de mesure de valeur effective de courant et le circuit de détermination de vol d'électricité par dérivation de fil neutre sont en état de veille, et le circuit de mesure d'énergie électrique est en état de veille ou en état de fonctionnement,
le circuit de commande de mode de fonctionnement comprenant une broche de commande de mode de fonctionnement, un circuit de surveillance de broche de commande, une minuterie à faible consommation d'énergie et un circuit de commutation de mode de fonctionnement,
la broche de commande de mode de fonctionnement étant conçue pour être connectée à la puce de commande principale et recevoir le signal de commande envoyé par la puce de commande principale ;
le circuit de surveillance de broche de commande est conçu pour surveiller le signal de commande, lorsque l'alimentation principale est mise sous tension, la puce de mesure d'énergie électrique monophasée passant en mode de mesure normal, et lorsque l'alimentation principale n'est pas sous tension, la puce de mesure d'énergie électrique monophasée passant en mode de veille à faible consommation d'énergie ;
la minuterie à faible consommation d'énergie est conçue pour surveiller si une période de réveil programmée T est atteinte dans le mode de veille à faible consommation d'énergie, et pour réveiller la puce de mesure d'énergie électrique monophasée afin de passer en mode de fonctionnement à réveil programmé lorsque la période de réveil programmée T est atteinte ; et le circuit d'horloge fournit une source d'horloge basse fréquence pour la minuterie à faible consommation d'énergie ; et
le circuit de commutation de mode de fonctionnement est conçu pour commuter entre le mode de veille à faible consommation d'énergie, le mode de fonctionnement à réveil programmé et le mode de mesure de prévention de vol d'électricité par dérivation de fil neutre, la commutation entre le mode de veille à faible consommation d'énergie, le mode de fonctionnement à réveil programmé et le mode de mesure de prévention de vol d'électricité par dérivation de fil neutre comprenant :
étape 1 : la configuration, par la puce de commande principale, des paramètres prédéfinis, les paramètres prédéfinis comprenant :
la période de réveil programmé T pour passer du mode de veille à faible consommation d'énergie au mode de fonctionnement à réveil programmé ; et
une fréquence d'horloge de fonctionnement du circuit d'échantillonnage de CAN, une fréquence d'horloge de fonctionnement du circuit de détermination de vol d'électricité par dérivation de fil neutre, une fréquence d'horloge de fonctionnement du circuit de mesure de valeur effective de courant et une fréquence d'horloge de fonctionnement du circuit de mesure d'énergie électrique après le passage en mode de fonctionnement à réveil programmé ;
étape 2 : le passage, par la puce de mesure d'énergie électrique monophasée, au mode de fonctionnement à réveil programmé pour réveiller le circuit d'échantillonnage de CAN et le circuit de détermination de vol d'électricité par dérivation de fil neutre en mode de veille à faible consommation d'énergie lorsque la période de réveil programmé T est atteinte ;
étape 3 : l'échantillonnage, par le circuit d'échantillonnage de CAN, du signal de courant pour obtenir le signal numérique ; et la pré-détermination, par le circuit de détermination de vol d'électricité par dérivation de fil neutre, du signal numérique pour déterminer s'il y a du courant dans la boucle de courant ;
étape 4 : s'il n'y a pas de courant dans la boucle de courant, la sortie du mode de fonctionnement à réveil programmé et le retour au mode de veille à faible consommation d'énergie ; et s'il y a du courant dans la boucle de courant, le réveil le circuit de mesure de valeur effective de courant pour mesurer la valeur effective de courant ;
étape 5 : la détermination précise, par le circuit de détermination de vol d'électricité par dérivation de fil neutre, de la valeur effective de courant, si la valeur effective de courant est inférieure au seuil de prévention de vol d'électricité par dérivation de fil neutre et si la puce de mesure d'énergie électrique monophasée est également en mode de mesure de prévention de vol d'électricité par dérivation de fil neutre à ce moment-là, le passage, par le circuit de mesure d'énergie électrique à l'état de veille, la sortie du mode de mesure de prévention de vol d'électricité par dérivation de fil neutre et du mode de fonctionnement à réveil programmé, et le passage au mode de veille à faible consommation d'énergie ; si la puce de mesure d'énergie électrique monophasée n'est pas en mode de mesure de prévention de vol d'électricité par dérivation de fil neutre à ce moment-là, la sortie du mode de fonctionnement à réveil programmé et le passage au mode de veille à faible consommation d'énergie ; et après le passage au mode de veille à faible consommation d'énergie, la répétition de l'étape 2 ; et
si la valeur effective de courant dépasse le seuil de prévention de vol d'électricité par dérivation de fil neutre, et si la puce de mesure d'énergie électrique monophasée est en mode de mesure de prévention de vol d'électricité par dérivation de fil neutre, l'exécution de l'étape 6 ; sinon, le réveil du circuit de mesure d'énergie électrique pour passer au mode de mesure de prévention de vol d'électricité par dérivation de fil neutre afin d'exécuter l'étape 6 ; et
étape 6 : l'exécution, par le circuit de mesure d'énergie électrique, du calcul d'accumulation d'énergie sur la valeur effective de courant pour obtenir l'impulsion d'énergie ; et le maintien, par la puce de mesure d'énergie électrique monophasée, du mode de mesure de prévention de vol d'électricité par dérivation de fil neutre, ce qui signifie que le circuit de mesure d'énergie électrique est en mode de fonctionnement et que la puce de mesure d'énergie électrique monophasée passe simultanément en mode de veille à faible consommation d'énergie, et la répétition de l'étape 2.

2. Puce de mesure d'énergie électrique monophasée pour une application de prévention de vol d'électricité par dérivation de fil neutre selon la revendication 1, la pré-déterminaiton, par le circuit de détermination de vol d'électricité par dérivation de fil neutre, du signal numérique pour déterminer s'il y a du courant dans la boucle de courant à l'étape 3 comprenant :
si les valeurs d'échantillonnage de plus de n points d'échantillonnage continus du signal numérique dépassent un premier seuil V dans un demi-cycle, la détermination qu'un courant traverse la boucle de courant ; sinon, la détermination qu'aucun courant ne traverse la boucle de courant, la valeur de n étant fixée en fonction d'un nombre N de points d'échantillonnage du signal numérique dans un cycle et de la première valeur de seuil V ; et
l'adoption, par le circuit de détermination de vol d'électricité par dérivation de fil neutre, d'une horloge haute fréquence comme source d'horloge.

3. Puce de mesure d'énergie électrique monophasée pour une application de prévention de vol d'électricité par dérivation de fil neutre selon la revendication 2, l'exécution, par le circuit de mesure d'énergie électrique, du calcul d'accumulation d'énergie sur la valeur effective de courant pour obtenir l'impulsion d'énergie à l'étape 6 comprenant :
étape 6.1 : l'exécution d'un calcul d'accumulation d'énergie sur la valeur effective de courant afin d'obtenir des données d'énergie ; et
étape 6.2 : la détermination du fait que les données d'énergie atteignent un seuil d'impulsion Th_{CF}, et si les données d'énergie n'atteignent pas le seuil d'impulsion TH_{CF}, la poursuite de l'étape 6.1 ; et
si les données d'énergie atteignent le seuil d'impulsion Th_{CF}, l'ajout de 1 à un compteur d'impulsions énergétiques ; si une fonction de sortie CF est activée, l'émission, par un port de sortie, de l'impulsion d'énergie vers la puce de commande principale, et la soustraction simultanée du seuil d'impulsion Th_{CF} aux données d'énergie, puis la poursuite de l'étape 6.1.

4. Puce de mesure d'énergie électrique monophasée pour une application de prévention de vol d'électricité par dérivation de fil neutre selon la revendication 3, en mode de mesure de prévention de vol d'électricité par dérivation de fil neutre à l'étape 6, le circuit de mesure d'énergie électrique adoptant une horloge basse fréquence comme source d'horloge.

5. Puce de mesure d'énergie électrique monophasée pour une application de prévention de vol d'électricité par dérivation de fil neutre selon la revendication 4, le circuit d'horloge comprenant une broche d'entrée de signal d'horloge basse fréquence (1), un circuit PLL, un circuit de sélection d'horloge, un premier circuit de division de fréquence, un deuxième circuit de division de fréquence, un troisième circuit de division de fréquence et un quatrième circuit de division de fréquence,
une extrémité d'entrée de la broche d'entrée du signal d'horloge basse fréquence (1) entrant une horloge basse fréquence, une première extrémité de sortie de la broche d'entrée du signal d'horloge basse fréquence (1) étant connectée à un circuit de veille à faible consommation d'énergie, une deuxième extrémité de sortie de la broche d'entrée du signal d'horloge basse fréquence (1) étant connectée à une première extrémité d'entrée du circuit de sélection d'horloge, et une troisième extrémité de sortie de la broche d'entrée du signal d'horloge basse fréquence (1) étant connectée à une extrémité d'entrée du circuit PLL ;
une première extrémité de sortie du circuit PLL étant connectée à une extrémité d'entrée du premier circuit de division de fréquence, une deuxième extrémité de sortie du circuit PLL étant connectée à une extrémité d'entrée du deuxième circuit de division de fréquence, une troisième extrémité de sortie du circuit PLL étant connectée à une extrémité d'entrée du troisième circuit de division de fréquence, et une quatrième extrémité de sortie du circuit PLL étant connectée à une extrémité d'entrée du quatrième circuit de division de fréquence ;
une extrémité de sortie du premier circuit de division de fréquence étant connectée au circuit d'échantillonnage de CAN, une extrémité de sortie du deuxième circuit de division de fréquence étant connectée au circuit de détermination de vol d'électricité par dérivation de fil neutre, une extrémité de sortie du troisième circuit de division de fréquence étant connectée au circuit de mesure de valeur effective de courant, et une extrémité de sortie du quatrième circuit de division de fréquence étant connectée à une deuxième extrémité d'entrée du circuit de sélection de l'horloge ; et
une extrémité de sortie du circuit de sélection d'horloge étant connectée au circuit de mesure d'énergie électrique, lorsque le mode de fonctionnement de la puce de mesure d'énergie électrique monophasée est le mode de mesure normal, le circuit de sélection d'horloge émettant l'horloge haute fréquence, et lorsque le mode de fonctionnement de la puce de mesure d'énergie électrique monophasée est le mode de mesure de prévention de vol d'électricité par dérivation de fil neutre, le circuit de sélection d'horloge émettant l'horloge basse fréquence.

6. Puce de mesure d'énergie électrique monophasée pour une application de prévention de vol d'électricité par dérivation de fil neutre selon la revendication 5, le circuit d'horloge comprenant un port de communication (2), un circuit de correction d'horloge, un circuit d'oscillation basse fréquence, un circuit d'oscillation haute fréquence, un circuit de sélection d'horloge, un premier circuit de division de fréquence, un deuxième circuit de division de fréquence, un troisième circuit de division de fréquence et un quatrième circuit de division de fréquence,
une extrémité d'entrée du port de communication (2) entrant les octets d'entraînement envoyés par la puce de commande principale, une extrémité de sortie du port de communication (2) étant connectée à une extrémité d'entrée du circuit de correction d'horloge, une première extrémité de sortie du circuit de correction d'horloge étant connectée à une extrémité d'entrée du circuit oscillant basse fréquence, et une deuxième extrémité de sortie du circuit de correction d'horloge étant connectée à une extrémité d'entrée du circuit oscillant haute fréquence ;
une première extrémité de sortie du circuit oscillant basse fréquence étant connectée au circuit de veille à faible consommation d'énergie, et une deuxième extrémité de sortie du circuit oscillant basse fréquence étant connectée à la première extrémité d'entrée du circuit de sélection d'horloge ;
une première extrémité de sortie du circuit oscillant haute fréquence étant connectée à une extrémité d'entrée du premier circuit de division de fréquence, une deuxième extrémité de sortie du circuit oscillant haute fréquence étant connectée à une extrémité d'entrée du deuxième circuit de division de fréquence, une troisième extrémité de sortie du circuit oscillant haute fréquence étant connectée à une extrémité d'entrée du troisième circuit de division de fréquence, et une quatrième extrémité de sortie du circuit oscillant haute fréquence étant connectée à une extrémité d'entrée du quatrième circuit de division de fréquence ;
une extrémité de sortie du premier circuit de division de fréquence étant connectée au circuit d'échantillonnage de CAN, une extrémité de sortie du deuxième circuit de division de fréquence étant connectée au circuit de détermination de vol d'électricité par dérivation de fil neutre, une extrémité de sortie du troisième circuit de division de fréquence étant connectée au circuit de mesure de valeur effective de courant, et une extrémité de sortie du quatrième circuit de division de fréquence étant connectée à une deuxième extrémité d'entrée du circuit de sélection de l'horloge ; et
une extrémité de sortie du circuit de sélection d'horloge étant connectée au circuit de mesure d'énergie électrique, lorsque le mode de fonctionnement de la puce de mesure d'énergie électrique monophasée est le mode de mesure normal, le circuit de sélection d'horloge émettant l'horloge haute fréquence, et lorsque le mode de fonctionnement de la puce de mesure d'énergie électrique monophasée est le mode de mesure de prévention de vol d'électricité par dérivation de fil neutre, le circuit de sélection d'horloge émettant l'horloge basse fréquence.

7. Puce de mesure d'énergie électrique monophasée pour une application de prévention de vol d'électricité par dérivation de fil neutre selon la revendication 5 ou 6, les paramètres prédéfinis à l'étape 1 comprenant en outre un objet de mesure du circuit de mesure de valeur effective de courant, et l'objet de mesure comprenant la mesure simultanée de deux valeurs effectives du courant d'un fil sous tension et d'un fil neutre, ou la mesure soit de la valeur effective de courant du fil sous tension, soit de la valeur effective de courant du fil neutre ; lorsque la mesure simultanée des deux valeurs efficaces du courant du fil sous tension et du fil neutre est sélectionnée comme objet de mesure, après le réveil du circuit de mesure de valeur efficace de courant pour mesurer la valeur efficace de courant à l'étape 4, une grande valeur efficace de courant étant sélectionnée pour effectuer les étapes 5 et 6 ; et
s'il y a du courant dans la boucle de courant à l'étape 4, le circuit de mesure de valeur effective de courant étant réveillé pour mesurer la valeur effective de courant après avoir attendu un temps T1 ; et après que la valeur effective de courant a été mesurée, un module de CAN et le circuit de mesure de valeur effective de courant passant à l'état de veille.
